# EUROPEAN PATENT APPLICATION

(11) **EP 1 067 684 A2**
(43) Date of publication of application: **10.01.2001**
(21) Application number: 00114233.0
(22) Date of filing: 03.07.2000
(51) Int. Cl.: H03H 9/05

(54) **Supporting structure for piezoelectric resonator, and electronic device, ladder filter, and communication apparatus**

(30) Priority: 05.07.1999 JP 19032899
(71) Applicant: Murata Manufacturing Co., Ltd., Nagaokakyo-shi Kyoto-fu 617-8555 (JP)
(72) Inventor: Unami, Toshihiko, c/o (A170) Intell. Prop. Dept., Nagaokakyo-shi, Kyoto-fu 617-8555 (JP); Kakuda, Tatsunori, c/o (A170) Intell. Prop. Dept., Nagaokakyo-shi, Kyoto-fu 617-8555 (JP)
(74) Representative: Gossel, Hans K., Dipl.-Ing.

(57) **Abstract**

A piezoelectric device includes a substrate. The substrate is provided with pattern electrodes located on a major surface thereof. Intermediate portions of external electrodes of a piezoelectric resonator are supported by a supporting member at land electrodes provided at ends of the pattern electrodes. The supporting member includes a plurality of substantially cylindrical units made of nickel. A filler made of an epoxy resin is formed around the substantially cylindrical units.

## Description

### BACKGROUND OF THE INVENTION

### 1. Field of the Invention

The present invention relates to supporting structures for piezoelectric resonators, and relates to electronic devices, ladder filters, and communication apparatuses. In particular, the present invention relates to a supporting structure for a piezoelectric resonator in which the piezoelectric resonator using, for example, length vibration or spread vibration, is supported by a supporting member on a substrate at an approximate center of the piezoelectric resonator. The present invention also relates to an electronic device, such as a ceramic filter, discriminator, or a ceramic oscillator, to a ladder filter, and to a communication apparatus which include the supporting structures.

### 2. Description of the Related Art

The inventors of the present invention proposed a structure in which a piezoelectric resonator having a layered structure and using length vibration was provided with a supporting member made of a conductive resin at an intermediate portion in the longitudinal direction of the piezoelectric resonator, and was supported by and electrically connected to a substrate through the supporting member.

The inventors also proposed another structure in which a piezoelectric resonator having a layered structure was provided with a supporting member made of an insulative resin at an intermediate portion in the longitudinal direction of the piezoelectric resonator, supported by the supporting member on a substrate, and electrically connected to the substrate through wires or other suitable connectors.

In order to obtain superior resonance characteristics in a piezoelectric resonator, a flexible supporting member having low resiliency is used, thereby minimizing the effect on the deflection by the vibration of the piezoelectric resonator. On the other hand, a material having a high rupture strength is required to be used for the supporting member because it must have a strength that is sufficiently high so as to be durable against impacts caused by falling or other environmental conditions.

However, generally, the harder a material having high resiliency, the greater the strength of the material.

That is, there is no material that has high rupture strength and low resiliency at the same time, which is required for the supporting member of the piezoelectric resonator. It is difficult for supporting strength and resonance characteristics of the piezoelectric resonator to be compatible with each other. For example, when the piezoelectric resonator is fixed to land electrodes on the substrate by soldering or other suitable method, the adhesive strength between the piezoelectric resonator and the substrate is very high, while the deflection caused by the vibration of the piezoelectric resonator is remarkably decreased, thereby deteriorating the resonance characteristics. On the other hand, when the piezoelectric resonator is supported by the substrate through a relatively soft resin member, such as a urethane resin element, sufficient strength against impacts caused by falls or other conditions cannot be ensured because the urethane resin has low rupture strength.

### SUMMARY OF THE INVENTION

To overcome the problems described above, preferred embodiments of the present invention provide a supporting structure for a piezoelectric resonator having high strength against impacts, in which superior resonance characteristics are obtained.

In addition, preferred embodiments of the present invention provide an electronic device, a ladder filter, and a communication apparatus, each using the supporting structure for a piezoelectric resonator having high strength against impacts, in which superior resonance characteristics are obtained.

According to one preferred embodiment of the present invention, a supporting structure for a piezoelectric resonator preferably includes a piezoelectric resonator, a substrate, and a supporting member for supporting the piezoelectric resonator on the substrate at an approximate center of a major surface of the piezoelectric resonator. The piezoelectric resonator vibrates in a direction that is substantially parallel to the major surface. The supporting member is made of a first material having relatively high rupture strength and high resiliency and a second material having relatively low rupture strength and low resiliency. The interface between the first and second materials is arranged substantially perpendicular to the major surface of the piezoelectric resonator.

The piezoelectric resonator may use length vibration, and the interface between the materials may be arranged substantially perpendicular to a surface of the substrate.

The supporting member may include at least one substantially cylindrical unit extending substantially perpendicular to the major surface of the piezoelectric resonator and a filler arranged around the substantially cylindrical unit. The substantially cylindrical unit has a rupture strength higher than the rupture strength of the filler, and the filler has a resiliency lower than the resiliency of the substantially cylindrical unit.

In the supporting structure for a piezoelectric resonator according to preferred embodiments of the present invention, the piezoelectric resonator may have a layered structure including a piezoelectric layer and electrodes laminated in the longitudinal direction of the major surface of the piezoelectric resonator, and may use length vibration in the longitudinal direction of the major surface of the piezoelectric resonator.

In the supporting structure for a piezoelectric resonator according to preferred embodiments of the present invention, an insulating film may be arranged on a part of one of the major surface and side surfaces of the piezoelectric resonator at which the electrodes are exposed, and two external electrodes may be located on one of the major surface and the side surfaces of the piezoelectric resonator, which include a surface of the insulating film, whereby the electrodes are connected to one of the two external electrodes.

The material of the substantially cylindrical unit having relatively high rupture strength and high resiliency may be made of a material selected from the group consisting of a resin, a metal, and a resin coated with a metal, and the other material for the filler having relatively low rupture strength and low resiliency may be made of an insulative resin.

In the supporting structure for a piezoelectric resonator according to preferred embodiments of the present invention, land electrodes may be arranged to project from the surface of the substrate, and the piezoelectric resonator may be supported by the supporting member on the land electrodes.

In the supporting structure for a piezoelectric resonator according to preferred embodiments of the present invention, two external electrodes may be located on one of the side surfaces of the piezoelectric resonator, and each of the two external electrodes may be electrically connected to one of the land electrodes through the supporting member.

According to another preferred embodiment of the present invention, an electronic device preferably includes a supporting structure for a piezoelectric resonator according to preferred embodiments of the support structure described above.

According to an additional preferred embodiment of the present invention, a ladder filter is provided in which a plurality of piezoelectric resonators are disposed on a substrate by using a supporting structure for a piezoelectric resonator according to preferred embodiments of the support structure described above.

According to a still further preferred embodiment of the present invention, a communication apparatus preferably includes one of a supporting structure for a piezoelectric resonator and a ladder filter according to preferred embodiments described above.

A problem to be solved in known technologies is the compatibility of the rupture strength of the supporting member with the resiliency thereof.

In a supporting member for supporting a piezoelectric resonator on a substrate, the piezoelectric resonator using length vibration or spread vibration, rupture strength is required to be active in a direction in which the piezoelectric resonator peels off of the substrate, that is, in a direction that is perpendicular to the surface of the substrate (Z-direction). The rupture strength is not required in a direction that is parallel to the surface of the substrate (X-Y directions). Since the piezoelectric resonator vibrates in the X-Y directions, resiliency of the supporting member is required to be low in those directions, and the resiliency in the Z-direction is not important.

In view of the above, the supporting member according to preferred embodiments of the present invention is provided with resiliency and rupture strength which are made different according to the orientation and arrangement thereof.

In the supporting structure for a piezoelectric resonator according to preferred embodiments of the present invention, the supporting member includes an element such as a substantially cylindrical unit having relatively high rupture strength and resiliency, and another element such as a filler having relatively low rupture strength and resiliency. The element such as the substantially cylindrical unit is disposed substantially perpendicular to the substrate, whereby the supporting member has a high rupture strength in the Z-direction and a low resiliency in the X-Y directions.

The piezoelectric resonator vibrates in the X-Y directions, while tensile force to break the junction between the substrate and the piezoelectric resonator is applied in the Z-direction.

In the supporting member of a piezoelectric resonator according to preferred embodiments of the present invention, by virtue of a low resiliency in the X-Y directions of the supporting member, superior resonance characteristics are ensured, and by virtue of a high rupture strength in the Z-direction, a very high strength against impacts due to falls and other conditions is achieved.

Other features, characteristics, elements and advantages of the present invention will become apparent from the following description of preferred embodiments thereof with reference to the attached drawings.

### BRIEF DESCRIPTION OF THE DRAWINGS

Fig. 1 is a perspective view of a piezoelectric device according to a first preferred embodiment of the present invention;
Fig. 2 is an exploded perspective view of the piezoelectric device shown in Fig. 1;
Fig. 3 is a perspective view of a piezoelectric resonator used in the piezoelectric device shown in Fig. 1;
Fig. 4 is a perspective view of a piezoelectric device according to a second preferred embodiment of the present invention;
Fig. 5 is an exploded perspective view of the piezoelectric device shown in Fig. 4;
Fig. 6 is a side view of a piezoelectric device according to a third preferred embodiment of the present invention;
Fig. 7 is an exploded perspective view of the piezoelectric device shown in Fig. 6;
Fig. 8 is an illustration of a piezoelectric device according to a fourth preferred embodiment of the present invention;
Fig. 9 is an illustration showing a process of forming a supporting member of the piezoelectric device shown in Fig. 8;
Fig. 10 is an exploded perspective view of a piezoelectric device according to a fifth preferred embodiment of the present invention;
Fig. 11 is a plan view of an example of a ladder filter according to preferred embodiments of the present invention;
Fig. 12 is an exploded perspective view of the ladder filter shown in Fig. 11;
Fig. 13 is a schematic diagram of the ladder filter shown in Fig. 11; and
Fig. 14 is a block diagram of an example of a double superheterodyne receiver according to a preferred embodiment of the present invention.

### DETAILED DESCRIPTION OF PREFERRED EMBODIMENTS

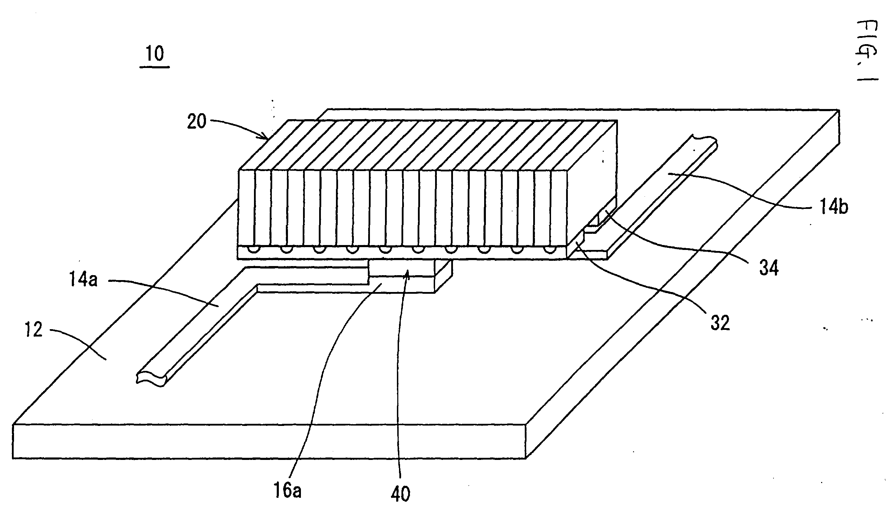

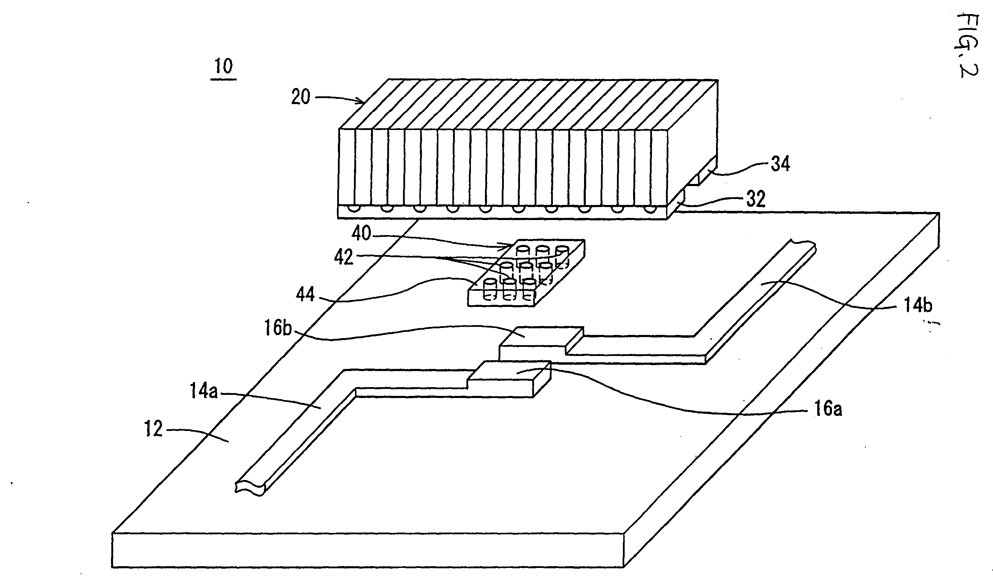

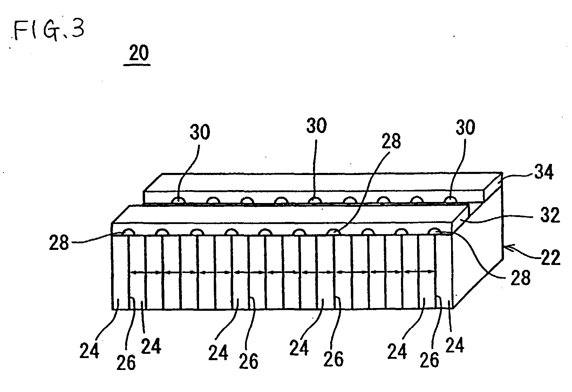

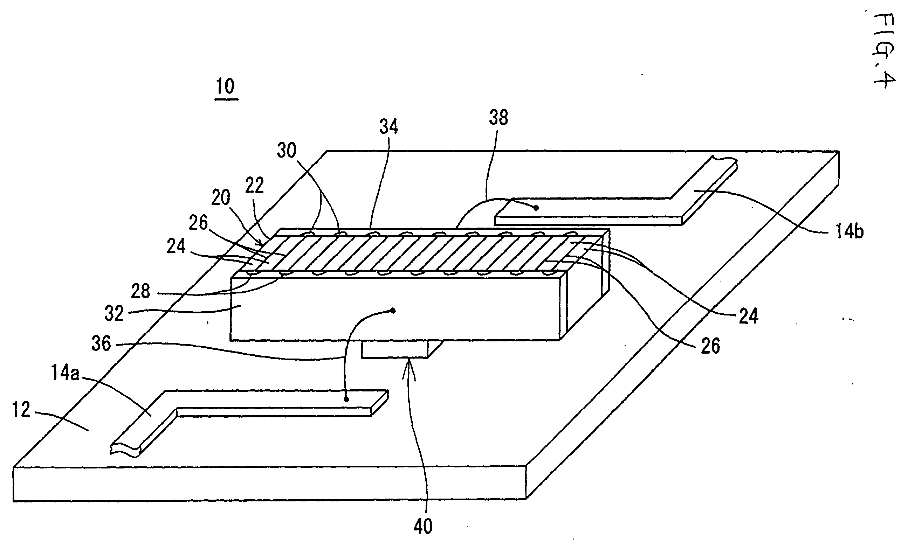

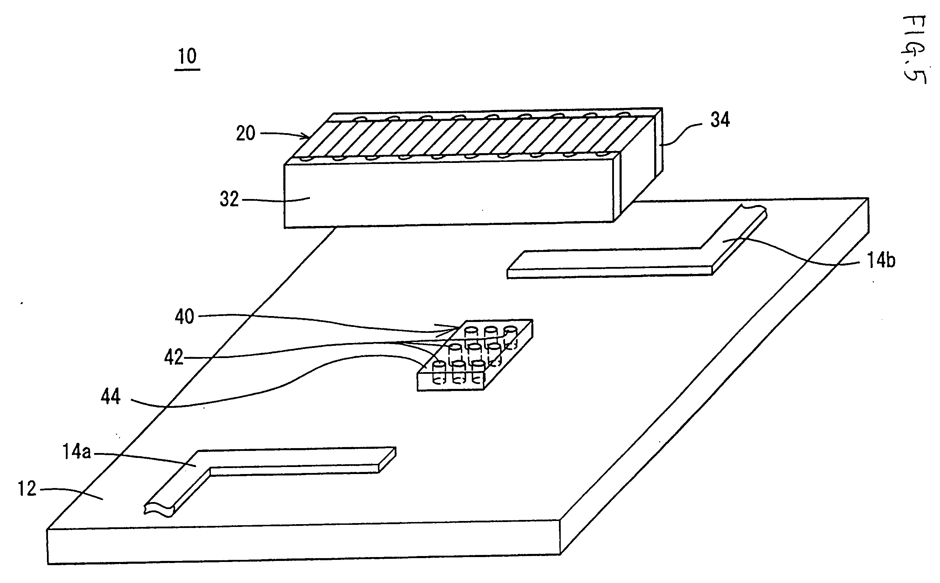

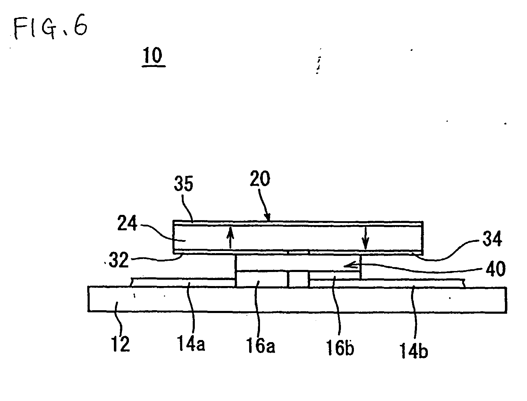

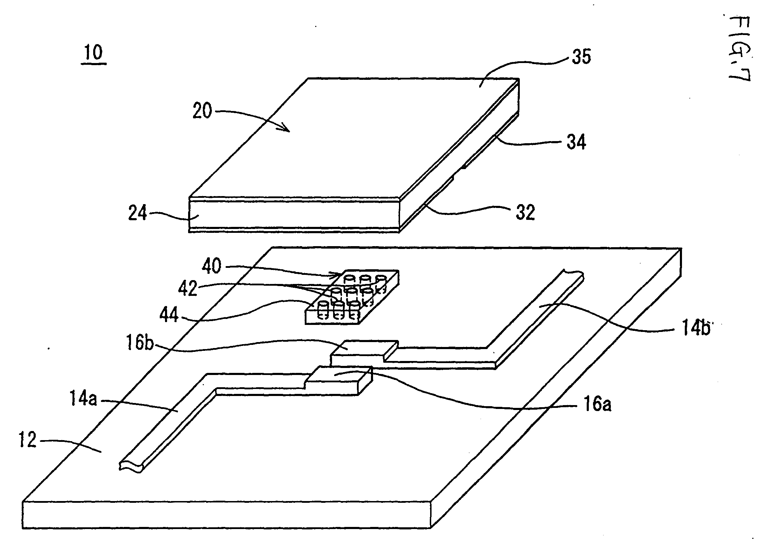

Fig. 1 is a perspective view of a piezoelectric device according to a first preferred embodiment of the present invention. Fig. 2 is an exploded perspective view of the same. Fig. 3 is a perspective view of a piezoelectric resonator included in the piezoelectric device shown in Figs. 1 and 2.

A piezoelectric device 10 shown in Fig. 1 preferably includes a substrate 12 made of, for example, a glass epoxy resin. The substrate 12 is provided preferably with two pattern-electrodes 14a and 14b located on one of the major surfaces of the substrate 12 across a gap therebetween. The pattern electrode 14a has a substantially L-shaped configuration and an end that extends toward the center of the substrate 12. The pattern electrode 14b also has a substantially L-shaped configuration and an end that extends toward the center of the substrate 12. The ends of the pattern electrodes 14a and 14b define land electrodes 16a and 16b which project by, for example, about 0.1 mm from the surface of the substrate 12.

The land electrodes 16a and 16b of the pattern electrodes 14a and 14b, respectively, support a multilayer piezoelectric resonator 20 through a supporting member 40 at an intermediate portion in the longitudinal direction of the piezoelectric resonator 20.

Referring to Fig. 3, the piezoelectric resonator 20 preferably includes a substantially rectangular base member 22 having, for example, a length of about 4 mm, a width of about 0.5 mm, and a thickness of about 0.4 mm. The base member 22 made of, for example, a piezoelectric ceramic includes twenty piezoelectric layers 24 arranged in a laminated construction. The piezoelectric layers 24 preferably have a uniform size. Each of the piezoelectric layers 24 is polarized in a direction opposite to the direction of polarization of the piezoelectric layers 24 adjacent thereto in the longitudinal direction of the base member 22. The piezoelectric layer 24 disposed at each longitudinal end of the base member 22 is not polarized.

The base member 22 is provided with internal electrodes 26 disposed between each of the twenty piezoelectric layers 24. The internal electrodes 26 extend substantially perpendicular to the longitudinal direction of the base member 22 and are separated from each other in the longitudinal direction of the base member 22. The internal electrodes 26 are arranged to cover the entire major surface of each piezoelectric layer 24. The internal electrodes 26 are exposed at the major surfaces and the side surfaces of the base member 22.

Ends of alternate internal electrodes (first alternate internal electrodes) 26 are covered by insulating films 28 at one widthwise side of one of the major surfaces of the base member 22. Ends of the other alternate internal electrodes (second alternate internal electrodes) 26 are covered by insulating films 30 at the other widthwise side of the major surface of the base member 22.

An external electrode 32 is provided on the major surface of the base member 22 across the insulating films 28 provided on the first alternate internal electrodes 26, and is connected to the second alternate internal electrodes 26. An external electrode 34 is disposed on the major surface of the base member 22 across the insulating films 30 provided on the second alternate internal electrodes 26, and is connected to the first alternate internal electrodes 26.

In the piezoelectric resonator 20 shown in Fig. 3, the external electrodes 32 and 34 function as input/output electrodes. By inputting signals to the external electrodes 32 and 34, electrical fields are applied between the internal electrodes 26 of the adjacent layers, thereby piezoelectrically activating each of the piezoelectric layers 24 except the piezoelectric layers 24 at the longitudinal ends of the base member 22. In this case, each electrical field opposite to the adjacent electrical fields is applied to each piezoelectric layer 24 of the base member 22 polarized in a direction opposite to the adjacent piezoelectric layers 24, whereby the piezoelectric layers 24, as a unit, expand or contract in the same direction. That is, an alternating electrical field in the longitudinal direction of the base member 22 is applied to each of the piezoelectric layers 24 through the internal electrodes 26 connected to the external electrodes 32 and 34, thereby driving each piezoelectric layer 24 to expand or contract, whereby a basic length vibration is generated in the piezoelectric resonator 20 with a node at a longitudinal intermediate portion of the base member 22.

Referring now to Fig. 2, the supporting member 40 preferably includes a plurality of substantially cylindrical units 42 made of, for example, nickel in a substantially cylindrical shape having a diameter of about 0.005 mm. A filler 44 is disposed around the substantially cylindrical units 42. In this preferred embodiment of the present invention, the filler 44 is preferably made of, for example, an epoxy resin and has a length of about 1 mm, a width of about 0.5 mm, and a thickness of about 0.05 mm. The plurality of substantially cylindrical units 42 are disposed across a gap of, for example, approximately 0.025 mm between each other, passing through the filler 44 in the thickness direction.

The piezoelectric resonator 20 is supported by the supporting member 40 on the land electrodes 16a and 16b of the pattern electrodes 14a and 14b at longitudinal intermediate portions of the external electrodes 32 and 34 provided on the piezoelectric resonator 20. The external electrodes 32 and 34 of the piezoelectric resonator 20 are electrically connected to the land electrodes 16a and 16b of the pattern electrodes 14a and 14b, respectively, through the substantially cylindrical units 42 of the supporting member 40.

**Table 1**

| | Cylindrical unit | Filler | Supporting member | | |
|---|---|---|---|---|---|
| | | | In X-Y direction | In Z-direction | Required value |
| Resiliency (×10⁹ N/m²) | 1499 | 45.77 | 47.92 | 103.9 | 49 or less in X-direction |
| Rupture strength (×10⁹ N/m²) | 0.49 | 0.059 | 0.059 | 0.076 | 0.069 or greater in Z-direction |

Table 1 shows the resiliency and the rupture strength required of components included in the piezoelectric device 10 shown in Figs. 1 and 2. In order to obtain superior resonance characteristics while maintaining sufficient strength, the resiliency of the supporting member 40 in the X-Y directions is preferably not more than about 49×10⁹ N/m² and the rupture strength of the same in the Z-direction is preferably not less than about 0.069×10⁹ N/m², which is found, in Table 1, to be possible in various preferred embodiments of the present invention.

In the piezoelectric device 10 shown in Figs. 1 and 2, the piezoelectric resonator 20 is supported on the substrate 12 by the supporting member 40 having a relatively low resiliency in the vibration direction of the piezoelectric resonator 20 using length vibration and having a relatively high rupture strength in a direction in which the piezoelectric resonator 20 peels away, whereby superior resonance characteristics are achieved and the strength against impacts due to falls and other conditions is greatly increased.

The piezoelectric device 10 shown in Figs. 1 and 2 includes the supporting member 40 having the substantially cylindrical units 42 made of conductive nickel and the filler 44 of an insulative epoxy resin. The supporting member 40 also functions to electrically connect the external electrodes 32 and 34 of the piezoelectric resonator 20 to the land electrodes 16a and 16b of the pattern electrodes 14a and 14b, respectively, provided on the substrate 12. The supporting member 40, which has the substantially cylindrical units 42 disposed across a gap between each other, is conductive in the Z-direction and is insulative in the X-Y directions. As a result of this novel structure and configuration, the distance between the land electrodes is greatly reduced without causing problems such as short circuiting and the like, thereby allowing the piezoelectric device 10 to be greatly reduced in size.

In the piezoelectric device 10 shown in Figs. 1 and 2, the land electrodes 16a and 16b of the pattern electrodes 14a and l4b are arranged to project from the surface of the substrate 10. Due to this configuration, a sufficient gap is ensured between an end of the piezoelectric resonator 20 and the surface of the substrate 12 so as not to suppress or hinder the vibration of the piezoelectric resonator 20, even when the piezoelectric resonator 20 is mounted slightly inclined, thereby yielding superior resonance characteristics.

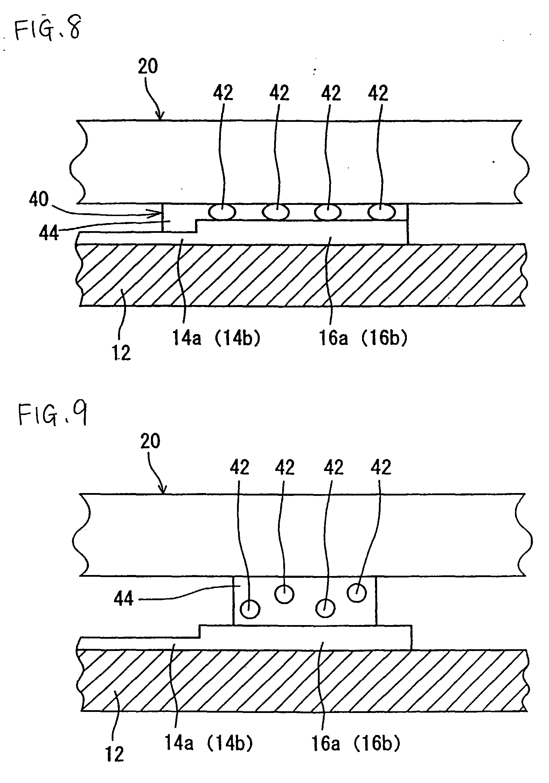

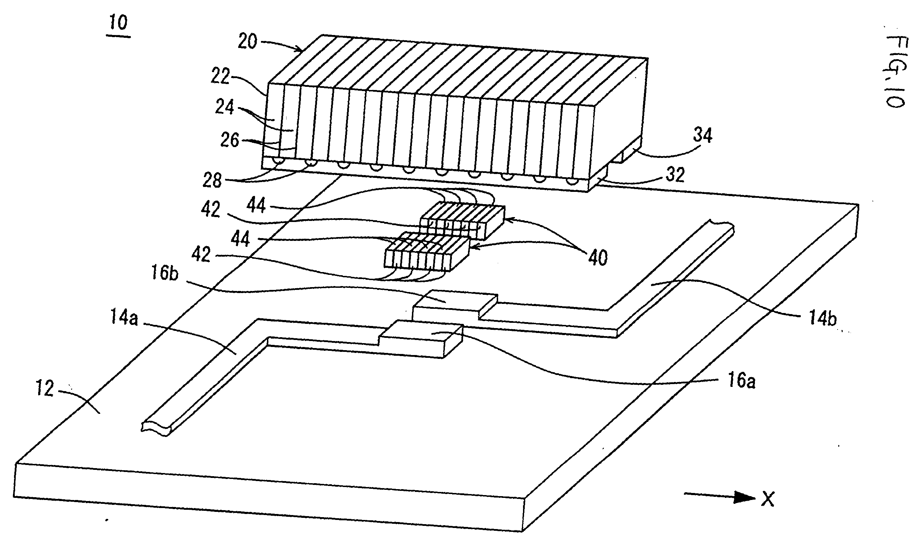

Fig. 4 is a perspective view of a piezoelectric device 10 according to a second preferred embodiment of the present invention, and Fig. 5 is an exploded perspective view of the same. In the piezoelectric device 10 shown in Figs. 4 and 5, pattern electrodes 14a and 14b are disposed across a larger gap therebetween than that provided between the pattern electrodes 14a and 14b of the piezoelectric device 10 shown in Figs. 1 and 2, according to the first preferred embodiment.

In the piezoelectric device 10 shown in Figs. 4 and 5, a piezoelectric resonator 20 preferably includes first alternate internal electrodes 26 having ends covered by insulating films 28 at one side of a base member 22, and the other alternate internal electrodes (second alternate internal electrodes) 26 having ends being covered by insulating films 30 at the other side of the base member 22. An external electrode 32 is formed on the insulating films 28 provided on the first alternate internal electrodes 26 at the side of the base member 22. An external electrode 34 is formed on the insulating films 30 provided on the second alternate internal electrodes 26 at the other side of the base member 22.

A supporting member 40 includes a plurality of substantially cylindrical units 42 preferably made of an epoxy resin and a filler 44 preferably made of a urethane resin.

The piezoelectric resonator 20 is supported on a surface of a substrate 12 by the supporting member 40 at a longitudinal intermediate portion of the major surface of the piezoelectric resonator 20 which is not provided with the external electrodes 32 and 34.

The external electrodes 32 and 34 of the piezoelectric resonator 20 are electrically connected to the pattern electrodes 14a and 14b through wires 36 and 38, respectively. However, other suitable connections can also be used.

The piezoelectric device 10 according to the second preferred embodiment shown in Figs. 4 and 5 includes, in the same way as in the piezoelectric device 10 according to the first preferred embodiment shown in Figs. 1 and 2, the supporting member having low resiliency in the X-Y directions and high rupture strength in the Z-direction, whereby the vibration of the piezoelectric resonator 20 is not suppressed or hindered, thereby yielding superior resonance characteristics and ensuring strength sufficient against impacts due to falls or other conditions.

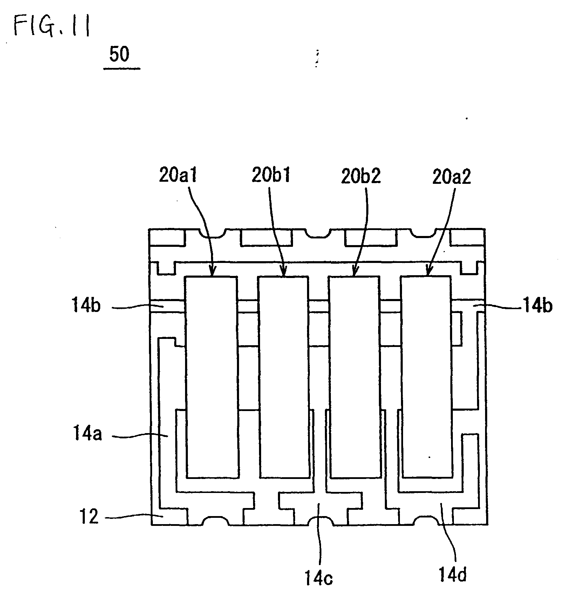

Fig. 6 is a side view of a piezoelectric device according to a third preferred embodiment of the present invention. Fig. 7 is an exploded perspective view of the piezoelectric device. A piezoelectric device 10 shown in Figs. 6 and 7 is different from the piezoelectric device 10 according to the first preferred embodiment shown in Figs. 1 and 2, in that the piezoelectric device 10 shown in Figs. 6 and 7 includes a piezoelectric resonator 20 that is constructed to vibrate in the spread vibration mode. The piezoelectric resonator 20 includes a substantially square plate-shaped piezoelectric layer 24. Two external electrodes 32 and 34 are located on a major surface of the piezoelectric layer 24 by dividing one electrode provided on the major surface into two electrodes at an intermediate portion thereof. Another external electrode 35 is located on the other major surface of the piezoelectric layer 24. The piezoelectric layer 24 is polarized in the thickness direction. As shown by arrows in Fig. 6, the piezoelectric layer 24 is polarized in the thickness directions opposite to each other: in one direction in a portion provided with the external electrode 32 and in the other direction in a portion provided with the external electrode 34. The piezoelectric resonator 20 is supported by a supporting member 40 on land electrodes 16a and 16b of pattern electrodes 14a and 14b at the approximate center of the piezoelectric layer 24 of the piezoelectric resonator 20. The external electrodes 32 and 34 of the piezoelectric resonator 20 are electrically connected to the land electrodes 16a and 16b of the pattern electrodes 14a and 14b, respectively, through substantially cylindrical units 42 of the supporting member 40.

In the piezoelectric device 10 shown in Figs. 6 and 7, the direction of vibration of the piezoelectric resonator 22 using spread vibration is substantially parallel to the surface of the substrate 12, thereby yielding superior resonance characteristics and sufficient supporting strength, in the same way as in the operation of the piezoelectric resonator using length vibration according to preferred embodiments described above.

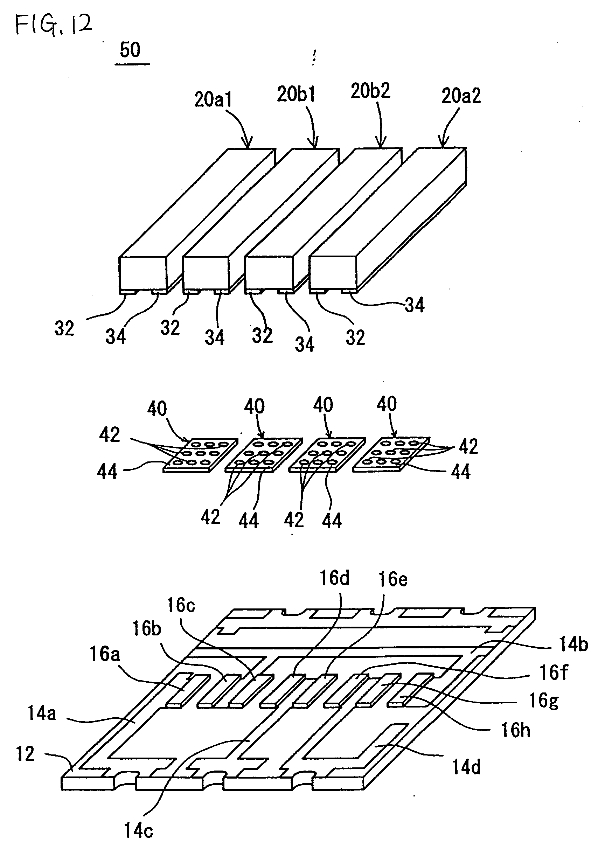

Fig. 8 is an illustration of a piezoelectric device according to a fourth preferred embodiment of the present invention. The piezoelectric device shown in Fig. 8 is different from the piezoelectric device 10 according to the first preferred embodiment shown in Figs. 1 and 2, in that the piezoelectric device according to the fourth preferred embodiment shown in Fig. 8 includes a supporting member 40 in which substantially cylindrical units 42 are constructed in a shape of balls that are vertically compressed. Such a supporting member 40 can be formed using the following method. That is, an appropriate quantity of round resin grains to serve as the substantially cylindrical units 42 are mixed and dispersed in a resin to form a filler 44. As shown in Fig. 9, the mixed resin is disposed on a land electrode 16a (16b) of a pattern electrode 14a (14b) provided on a substrate 12, the piezoelectric resonator 20 is disposed on the mixed resin layer, and the thus-assembled components are compressed, heated, and cured, thereby forming the supporting member 40 shown in Fig. 8. By compressing when curing to form the supporting member 40 including the substantially cylindrical units 42 and the filler 44, the rupture strength in the direction of compression is greatly increased and the resiliency in a direction that is substantially perpendicular to the direction of compression is greatly decreased.

In the piezoelectric device shown in Fig. 8, the supporting member 40 has a low resiliency in the X-Y directions and a high rupture strength in the Z-direction, whereby the vibration of the piezoelectric resonator 20 is not suppressed, thereby yielding superior resonance characteristics and sufficient strength against impacts due to falls or other conditions.

The substantially cylindrical units 42 made of a resin, as described above, can be used in the piezoelectric device 10 according to the second preferred embodiment shown in Fig. 4, in which the substantially cylindrical units 42 are not required to be electrically conductive. The substantially cylindrical units 42 may be electrically conductive by using a material of a metal or a resin coated with a metal, whereby it can be used in the piezoelectric device 10 according to the first and third preferred embodiments shown in Figs. 1 and 6.

Fig. 10 is an exploded perspective view of a piezoelectric device 10 according to a fifth preferred embodiment of the present invention. The piezoelectric device 10 shown in Fig. 10 is different from the piezoelectric device 10, according to the first preferred embodiment, shown in Figs. 1 and 2, in that the piezoelectric device 10 shown in Fig. 10 includes a supporting member 40 having a plurality of plate-shaped units 42 extending in a direction that is substantially perpendicular to the longitudinal direction of a piezoelectric resonator 20, and the supporting member 40 is divided into two portions corresponding to lands 16a and 16b and external electrodes 32 and 34, respectively.

Only the resiliency in the X-direction of the supporting member 40 is important when the piezoelectric resonator 20 vibrates in the X-direction, such as in the case of the piezoelectric device 10, according to the fifth preferred embodiment, of which the supporting member 40 has a shape shown in Fig. 10. In the piezoelectric device 10 shown in Fig. 10, the piezoelectric resonator 20 is supported on a substrate 12 by the supporting member 40 having a relatively low resiliency in the vibration direction of the piezoelectric resonator 20 using length vibration and a relatively high rupture strength in a direction in which the piezoelectric resonator 20 peels away, thereby yielding superior resonance characteristics and a high strength against impacts due to falls or other conditions.

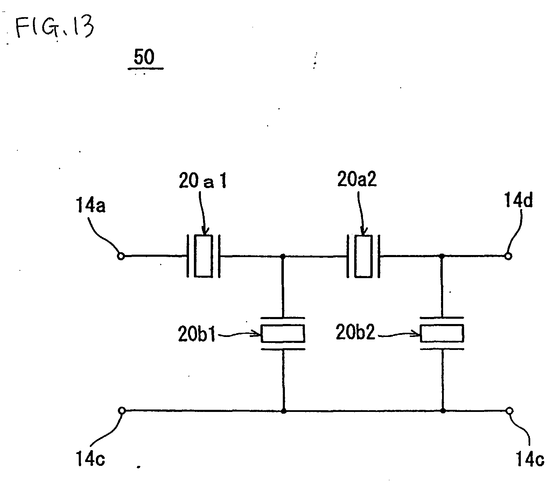

Fig. 11 is a plan view of a ladder filter 50 according to another preferred embodiment of the present invention, and Fig. 12 is an exploded perspective view of the same. The ladder filter 50 shown in Figs. 11 and 12 preferably has four pattern electrodes 14a, 14b, 14c, and 14d arranged across a gap therebetween on a major surface of a substrate 12. The pattern electrodes 14a to 14d are provided with eight land electrodes 16a to 16h disposed substantially parallel to each other across a gap therebetween. The land electrode 16a is located at an end of the pattern electrode 14a. The land electrodes 16b and 16c are located at an end of the pattern electrode 14b. The land electrodes 16d and 16e are located at an end of the pattern electrode 14c. The land electrode 16f and 16g are located at an end of the pattern electrode 14d. The land electrode 16h is located at the other end of the pattern electrode 14b.

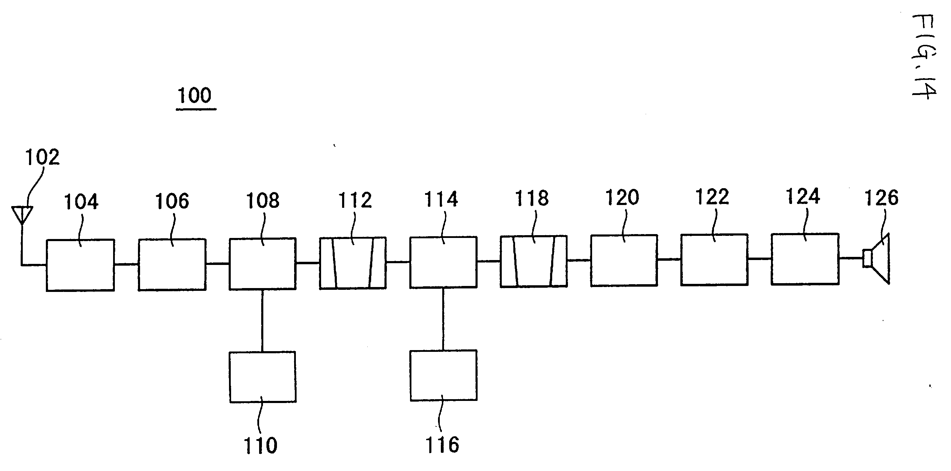

The eight land electrodes 16a to 16h on the substrate 12 support four piezoelectric resonators 20a1, 20b1, 20b2, and 20a2 at intermediate portions of each piezoelectric resonator through four supporting members 40. External electrodes of each piezoelectric resonator are electrically connected to the land electrodes through substantially cylindrical units 42 of the supporting members 40 in such a manner: external electrodes 32 and 34 of the piezoelectric resonator 20a1 to the land electrodes 16a and 16b, respectively, external electrodes 32 and 34 of the piezoelectric resonator 20b1 to the land electrodes 16c and 16d, respectively, external electrodes 32 and 34 of the piezoelectric resonator 20b2 to the land electrodes 16e and 16f, respectively, and external electrodes 32 and 34 of the piezoelectric resonator 20a2 to the land electrodes 16g and 16h, respectively. Fig. 13 is a schematic diagram of a circuit of the ladder filter 50 thus arranged.

Fig. 14 is a block diagram of a double superheterodyne receiver according to an additional preferred embodiment of the present invention. A double superheterodyne receiver 100 shown in Fig. 14 includes an antenna 102. The antenna 102 is connected to an input terminal of an input circuit 104. The input circuit 104 performs impedance matching between the antenna 102 and a high-frequency amplifier 106 described below. The input circuit 104 includes a tuning circuit or a band-pass filter for selecting a given wave. An output terminal of the input circuit 104 is connected to an input terminal of the high-frequency amplifier 106. The high-frequency amplifier 106 low-noise-amplifies an extremely-low-power electric wave and improves the sensitivity, and it improves selectivity of image frequency. An output terminal of the high-frequency amplifier 106 is connected to an input terminal of a first frequency mixer 108. The first frequency mixer 108 mixes the given wave and a local oscillator wave, and produces a first intermediate frequency wave with the sum or the difference thereof. The other input terminal of the first frequency mixer 108 is connected to an output terminal of a first local oscillator 110. The first local oscillator 110 outputs the first local oscillator wave for producing the first intermediate frequency wave. An output terminal of the first frequency mixer 108 is connected to an input terminal of a first band-pass filter 112. The first band-pass filter 112 transmits the first intermediate frequency wave. An output terminal of the first band-pass filter 112 is connected to an input terminal of a second frequency mixer 114. The second frequency mixer 114 mixes the first intermediate frequency wave and a second local oscillator wave, and produces a second intermediate frequency wave with the sum or the difference thereof. The other input terminal of the second frequency mixer 114 is connected to an output terminal of a second local oscillator 116. The second local oscillator 116 outputs the second local oscillator wave for producing the second intermediate frequency wave. An output terminal of the second frequency mixer 114 is connected to an input terminal of a second band-pass filter 118. The second band-pass filter 118 transmits the second intermediate frequency wave. An output terminal of the second band-pass filter 118 is connected to an input terminal of an intermediate frequency amplifier 120. The intermediate frequency amplifier 120 amplifies the second intermediate frequency wave. An output terminal of the intermediate frequency amplifier 120 is connected to an input terminal of a detector 122. The detector 122 obtains a signal wave from the second intermediate frequency wave. An output terminal of the detector 122 is connected to an input terminal of a low-frequency amplifier 124. The low-frequency amplifier 124 amplifies the signal wave to a level at which a speaker can be driven. An output terminal of the low-frequency amplifier 124 is connected to a speaker 126.

According to this preferred embodiment of the present invention, in the double superheterodyne receiver 100, the piezoelectric resonator according to the preferred embodiment described above may be used as the detector 122. The ladder filter according to the preferred embodiment described above may be used as the first band-pass filter 112 or the second band-pass filter 118.

According to preferred embodiments of the present invention, the piezoelectric resonator described above may be used as a detector, and the ladder filter described above may be used as a band-pass filter, in a single superheterodyne receiver.

Although a laminated-type piezoelectric resonator or a plate-shaped piezoelectric resonator is used in each piezoelectric device 10 or the ladder filter 50, as described above, the piezoelectric resonator using the vibration mode may also have a different configuration according to the present invention.

Although a supporting member having the configuration and shapes described above in each piezoelectric device 10 or the ladder filter 50, the material and the shape of the supporting member may be modified in a preferable manner according to the present invention. For example, the substantially cylindrical units may have other shapes and dimensions such as substantially square units, substantially triangular units, substantially rectangular units, and other suitable shapes and dimensions.

According to the present invention, a supporting structure for a piezoelectric resonator is provided, in which superior resonance characteristics and high strength against impacts are achieved.

In the supporting structure for a piezoelectric resonator according to the present invention, land electrodes are arranged to project from the surface of a substrate, and the piezoelectric resonator is supported by a supporting member on the land electrodes, whereby a sufficient distance between an end of the piezoelectric resonator and the surface of the substrate can be ensured when the piezoelectric resonator is mounted slightly inclined, thereby avoiding the suppression or hindrance of the vibration of the piezoelectric resonator while also yielding superior resonance characteristics.

According to the present invention, an electronic device, a ladder filter, and a communication apparatus using the supporting structure for a piezoelectric resonator are obtainable.

It should be understood that the foregoing description is only illustrative of the present invention. Various alternatives and modifications can be devised by those skilled in the art without departing from the invention. Accordingly, the present invention is intended to embrace all such alternatives, modifications and variations which fall within the scope of the appended claims.

## Claims

1. A supporting structure for supporting a piezoelectric resonator on a substrate, the supporting structure comprising:
a first portion made of a first material having relatively high rupture strength and high resiliency; and
a second portion made of a second material having relatively low rupture strength and low resiliency; wherein
the interface between the first and second materials is disposed substantially perpendicular to a major surface of the piezoelectric resonator.

2. A supporting structure according to claim 1, further comprising at least one substantially cylindrical unit extending substantially perpendicular to the major surface of the piezoelectric resonator and a filler disposed around the at least one substantially cylindrical unit.

3. A supporting structure according to claim 2, wherein the at least one substantially cylindrical unit has a rupture strength higher than the rupture strength of the filler, and the filler has a resiliency lower than the resiliency of the at least one substantially cylindrical unit.

4. A supporting structure according to claim 1, further comprising a plurality of substantially cylindrical units extending substantially perpendicular to the major surface of the piezoelectric resonator and a filler disposed around the plurality of substantially cylindrical units.

5. A supporting structure according to claim 4, wherein the plurality of substantially cylindrical units have a rupture strength higher than the rupture strength of the filler, and the filler has a resiliency lower than the resiliency of the plurality of substantially cylindrical units.

6. A supporting structure according to claim 2, wherein one of the first material and the at least one substantially cylindrical unit having relatively high rupture strength and high resiliency is made of a material selected from the group consisting of a resin, a metal, and a resin coated with a metal, and one of the second material and the filler having relatively low rupture strength and low resiliency is made of an insulative resin.

7. An electronic component comprising:
a piezoelectric resonator;
a substrate; and
a supporting member supporting the piezoelectric resonator on the substrate at an approximate center of a major surface of the piezoelectric resonator;
wherein the piezoelectric resonator vibrates in a direction that is substantially parallel to the major surface, the supporting member includes a first material having relatively high rupture strength and high resiliency and a second material having relatively low rupture strength and low resiliency, and the interface between the first and second materials is substantially perpendicular to the major surface of the piezoelectric resonator.

8. An electronic component according to Claim 7, wherein the piezoelectric resonator vibrates in a length vibration mode, and the interface between the first and second materials is substantially perpendicular to a surface of the substrate.

9. An electronic component according to Claim 7, wherein the supporting member includes at least one cylindrical unit extending substantially perpendicular to the major surface of the piezoelectric resonator and a filler disposed around the at least one substantially cylindrical unit, the at least one substantially cylindrical unit has a rupture strength higher than the rupture strength of the filler, and the filler has a resiliency lower than the resiliency of the at least one substantially cylindrical unit.

10. An electronic component according to Claim 7, wherein the piezoelectric resonator has a layered structure including piezoelectric layers and electrodes laminated in the longitudinal direction of the major surface of the piezoelectric resonator, and vibrates in the length vibration mode in the longitudinal direction of said major surface.

11. An electronic component according to Claim 10, wherein an insulating film is located on a portion of one of said major surface and side surfaces of the piezoelectric resonator at which said electrodes are exposed, and two external electrodes are located on one of said major surface and said side surfaces, which include a surface upon which the insulating film is mounted, of the piezoelectric resonator, whereby said electrodes are connected to one of the two external electrodes.

12. An electronic component according to Claim 7, wherein one of the first material and the at least one substantially cylindrical unit having relatively high rupture strength and high resiliency is made of a material selected from the group consisting of a resin, a metal, and a resin coated with a metal, and one of the second material and the filler having relatively low rupture strength and low resiliency is made of an insulative resin.

13. An electronic component according to Claim 7, wherein land electrodes are arranged to project from the surface of the substrate, and the piezoelectric resonator is supported by the land electrodes through the supporting member.

14. An electronic component according to Claim 13, wherein two external electrodes are located on one of the side surfaces of the piezoelectric resonator, and each of the two external electrodes is electrically connected to one of the land electrodes through said supporting member.

15. A ladder filter comprising:
a piezoelectric resonator;
a substrate; and
a supporting member supporting the piezoelectric resonator on the substrate at an approximate center of a major surface of the piezoelectric resonator;
wherein the piezoelectric resonator vibrates in a direction that is substantially parallel to the major surface, the supporting member includes a first material having relatively high rupture strength and high resiliency and a second material having relatively low rupture strength and low resiliency, and the interface between the first and second materials is substantially perpendicular to the major surface of the piezoelectric resonator.

16. A ladder filter according to Claim 15, wherein the piezoelectric resonator vibrates in a length vibration mode, and the interface between the first and second materials is substantially perpendicular to a surface of the substrate.

17. A ladder filter according to claim 15, wherein the supporting member includes at least one cylindrical unit extending substantially perpendicular to the major surface of the piezoelectric resonator and a filler disposed around the at least one substantially cylindrical unit, the at least one substantially cylindrical unit has a rupture strength higher than the rupture strength of the filler, and the filler has a resiliency lower than the resiliency of the at least one substantially cylindrical unit.

18. A ladder filter according to Claim 15, wherein the piezoelectric resonator has a layered structure including piezoelectric layers and electrodes laminated in the longitudinal direction of the major surface of the piezoelectric resonator, and vibrates in a length vibration mode in the longitudinal direction of said major surface.

19. A ladder filter according to Claim 18, wherein an insulating film is located on a portion of one of said major surface and side surfaces of the piezoelectric resonator at which said electrodes are exposed, and two external electrodes are located on one of said major surface and said side surfaces, which include a surface upon which the insulating film is located, of the piezoelectric resonator, whereby said electrodes are connected to one of the two external electrodes.

20. A ladder filter according to claim 15, wherein the first material and the at least one substantially cylindrical unit having relatively high rupture strength and high resiliency are made of a material selected from the group consisting of a resin, a metal, and a resin coated with a metal, and the second material and the filler having relatively low rupture strength and low resiliency are made of an insulative resin.

21. A ladder filter according to claim 15, wherein land electrodes are arranged to project from the surface of the substrate, and the piezoelectric resonator is supported by the land electrodes through the supporting member.

22. A ladder filter according to Claim 21, wherein two external electrodes are located on one of the side surfaces of the piezoelectric resonator, and each of the two external electrodes is electrically connected to one of the land electrodes through said supporting member.

23. A communication apparatus comprising:
a piezoelectric resonator;
a substrate; and
a supporting member supporting the piezoelectric resonator on the substrate at an approximate center of a major surface of the piezoelectric resonator;
wherein the piezoelectric resonator vibrates in a direction that is substantially parallel to the major surface, the supporting member includes a first material having relatively high rupture strength and high resiliency and a second material having relatively low rupture strength and low resiliency, and the interface between the first and second materials is substantially perpendicular to the major surface of the piezoelectric resonator.

24. A communication apparatus according to Claim 23, wherein the piezoelectric resonator vibrates in a length vibration mode, and the interface between the first and second materials is substantially perpendicular to a surface of the substrate.

25. A communication apparatus according to Claim 23, wherein the supporting member includes at least one cylindrical unit extending substantially perpendicular to the major surface of the piezoelectric resonator and a filler disposed around the at least one substantially cylindrical unit, the at least one substantially cylindrical unit has a rupture strength higher than the rupture strength of the filler, and the filler has a resiliency lower than the resiliency of the at least one substantially cylindrical unit.

26. A communication apparatus according to Claim 23, wherein the piezoelectric resonator has a layered structure including piezoelectric layers and electrodes laminated in the longitudinal direction of the major surface of the piezoelectric resonator, and vibrates in a length vibration mode in the longitudinal direction of said major surface.

27. A communication apparatus according to Claim 26, wherein an insulating film is located on a portion of one of said major surface and side surfaces of the piezoelectric resonator at which said electrodes are exposed, and two external electrodes are located on one of said major surface and said side surfaces, which include a surface upon which the insulating film is located, of the piezoelectric resonator, whereby said electrodes are connected to one of the two external electrodes.

28. A communication apparatus according to Claim 23, wherein the first material and the at least one substantially cylindrical unit having relatively high rupture strength and high resiliency are made of a material selected from the group consisting of a resin, a metal, and a resin coated with a metal, and the second material and the filler having relatively low rupture strength and low resiliency are made of an insulative resin.

29. A communication apparatus according to Claim 23, wherein land electrodes are arranged to project from the surface of the substrate, and the piezoelectric resonator is supported by the land electrodes through the supporting member.

30. A communication apparatus according to Claim 29, wherein two external electrodes are located on one of the side surfaces of the piezoelectric resonator, and each of the two external electrodes is electrically connected to one of the land electrodes through said supporting member.

31. A communication apparatus comprising:
a substrate;
a ladder filter defined by a plurality of piezoelectric resonators disposed on the substrate;
a supporting member supporting the plurality of piezoelectric resonators on the substrate at an approximate center of a major surface of the piezoelectric resonator;
wherein the piezoelectric resonator vibrates in a direction that is substantially parallel to the major surface, the supporting member includes a first material having relatively high rupture strength and high resiliency and a second material having relatively low rupture strength and low resiliency, and the interface between the first and second materials is substantially perpendicular to the major surface of the piezoelectric resonator.

32. A communication apparatus according to Claim 31, wherein the piezoelectric resonator vibrates in a length vibration mode, and the interface between the first and second materials is substantially perpendicular to a surface of the substrate.

33. A communication apparatus according to Claim 31, wherein the supporting member includes at least one cylindrical unit extending substantially perpendicular to the major surface of the piezoelectric resonator and a filler disposed around the at least one substantially cylindrical unit, the at least one substantially cylindrical unit has a rupture strength higher than the rupture strength of the filler, and the filler has a resiliency lower than the resiliency of the at least one substantially cylindrical unit.

34. A communication apparatus according to Claim 31, wherein the piezoelectric resonator has a layered structure including piezoelectric layers and electrodes laminated in the longitudinal direction of the major surface of the piezoelectric resonator, and vibrates in a length vibration mode in the longitudinal direction of said major surface.

35. A communication apparatus according to Claim 34, wherein an insulating film is located on a portion of one of said major surface and side surfaces of the piezoelectric resonator at which said electrodes are exposed, and two external electrodes are located on one of said major surface and said side surfaces, which include a surface upon which the insulating film is located, of the piezoelectric resonator, whereby said electrodes are connected to one of the two external electrodes.

36. A communication apparatus according to Claim 31, wherein the first material and the at least one substantially cylindrical unit having relatively high rupture strength and high resiliency are made of a material selected from the group consisting of a resin, a metal, and a resin coated with a metal, and the second material and the filler having relatively low rupture strength and low resiliency are made of an insulative resin.

37. A communication apparatus according to Claim 31, wherein land electrodes are arranged to project from the surface of the substrate, and the piezoelectric resonator is supported by the land electrodes through the supporting member.

38. A communication apparatus according to Claim 37, wherein two external electrodes are located on one of the side surfaces of the piezoelectric resonator, and each of the two external electrodes is electrically connected to one of the land electrodes through said supporting member.
